# EUROPÄISCHE PATENTSCHRIFT

(11) **EP 0 376 100 B1**
(45) Veröffentlichungstag und Bekanntmachung des Hinweises auf die Patenterteilung: **15.02.1995**
(21) Anmeldenummer: 89123316.5
(22) Anmeldetag: 16.12.1989
(51) Int. Cl.: H01L 23/373, H01L 23/538

(54) **Verfahren und Leiterplatte zum Montieren eines Halbleiter-Bauelements**
Method and lead frame for mounting a semiconductor
Procédé et cadre conducteur pour le montage d'un composant semi-conducteur

(30) Priorität: 24.12.1988 DE 3843787
(43) Veröffentlichungstag der Anmeldung: 04.07.1990
(73) Patentinhaber: Alcatel SEL Aktiengesellschaft, D-70435 Stuttgart (DE)
(72) Erfinder: Heidemann, Rolf, Dr., D-7146 Tamm (DE); Schlag, Erwin, D-7143 Vaihingen/E.7 (DE)
(74) Vertreter: Pohl, Herbert, Dipl.-Ing.

(56) Entgegenhaltungen:
- EP-A- 0 055 578
- EP-A- 0 065 425
- EP-A- 0 079 265
- WO-A-85/05496
- GB-A- 2 046 514
- IBM TECHNICAL DISCLOSURE BULLETIN, Band 22, Nr. 8A, Januar 1980, Seiten 3410-3414, New York, US; C.W. HO et al.: "Multiple LSI silicon chip modules withpower buses composed of laminated silicon sheets with metallized upper andlower surfaces"
- IBM TECHNICAL DISCLOSURE BULLETIN, Band 19, Nr. 11, April 1977, Seiten 4165-4166, New York, US; D. BALDERES et al.: "Heat dissipation from IC chips throughmodule package"
- JOURNAL OF APPLIED PHYSICS, Band 52, Nr. 8, August 1981, Seiten 5340-5349, NewYork, US; T.R. ANTHONY: "Forming electrical interconnections throughsemiconductor wafers"

## Beschreibung

Die Erfindung betrifft ein Verfahren zum Montieren eines mit einem Gehäuse versehenen Halbleiter-Bauelementes auf einer Leiterplatte und eine Leiterplatte mit mindestens einem Halbleiter-Bauelement.

Bei einer bekannten Leiterplatte ist das Halbleiter-Bauelement durch ein federndes Halteorgan auf einer Montageplatte befestigt, die als Kühlblech und als Befestigungsfläche dient (DE 35 16 489 C2). An Hochgeschwindigkeitsschaltungen, in denen Signale im Gbit/s- oder GHz-Bereich verarbeitet werden, sind hohe Anforderungen zu stellen. Zum Verkapseln der Halbleiter-Bauelemente - im folgenden auch als Chips bezeichnet - werden kleine Mikrowellengehäuse verwendet. Um die Zuleitungsinduktivitäten zu einem Chip möglichst klein zu halten, ist es nämlich nötig, Gehäuse mit nur wenigen Millimetern Kantenlänge zu verwenden. Solche Mikrowellengehäuse weisen außerdem einen Metallboden auf, über den sich auch bei kleinen Gehäuseabmessungen einige Watt an Verlustleistung abführen lassen. Insbesondere bei digitalen integrierten Schaltungen sind wegen der großen Anzahl der zu verarbeitenden Signale entsprechend viele Anschlußbeinchen oder Pins nötig. Die große Pinzahl und die kleinen Gehäuseabmessungen ergeben einen kleinen Pinabstand. Daraus ergibt sich die Schwierigkeit, trotz dieses geringen Pinabstands eine gute elektrische Entkopplung und eine wellenwiderstandsgerechte HF-Durchführung der Pins zu gewährleisten.

Es ist auch ein Verfahren zum Montieren eines mit einem Gehäuse versehenen Halbleiter-Bauelementes auf einer Leiterplatte bekannt (EP-A-55 578), bei dem
a) das Gehäuse mit einem wärmeleitenden Bauteil verbunden wird,
b) die Leiterplatte mit durchgehenden Bohrungen versehen wird, die in einer auf der Leiterplatte angeordneten Montagefläche münden, und
c) die Bohrungen mit einem schmelzflüssigen Lot gefüllt werden und dadurch das Gehäuse thermisch mit dem Halbleiter-Bauelement verbinden.

Es ist weiterhin ein Verfahren zum Montieren eines mit einem Gehäuse versehenen Halbleiter-Bauelementes auf einem Sockel bekannt (EP-A-79 265), bei dem
a) der Sockel mit durchgehenden Bohrungen versehen wird, die in einer auf dem Sockel angeordneten Montagefläche münden,
b) der Gehäuseboden auf die Montagefläche aufgesetzt wird, und
c) die Bohrungen mit einem schmelzflüssigen Lot gefüllt werden und dadurch das Gehäuse thermisch und elektrisch leitend mit auf dem Sockel versehenen Leiterbahnen verbinden. Der Sockel wird mit einem wärmeleitenden Bauteil verbunden.

Der Erfindung liegt die Aufgabe zugrunde, ein Verfahren und eine Leiterplatte zu schaffen, die für die Montage von Hochgeschwindigkeitschips, insbesondere von in Mikrowellengehäusen enthaltenen Chips geeignet sind.

Diese Aufgabe wird bei einem Verfahren zum Montieren eines mit einem Gehäuse versehenen Halbleiter-Bauelements auf einer Leiterplatte, erfindungsgemäß dadurch gelöst,
- daß die Leiterplatte als Multilayer ausgebildet ist,
- daß der Multilayer mit durchgehenden Bohrungen versehen wird, welche in einer auf ihm vorhandenen Montagefläche münden, und einige der im Multilayer enthaltenen flächigen Leiterbahnen bis zur Innenfläche der Bohrungen geführt werden,
- daß der Gehäuseboden auf die Montagefläche aufgesetzt wird, und
- daß die Bohrungen mit einem schmelzflüssigen Lot gefüllt und dadurch das Gehäuse thermisch und elektrisch leitend mit den flächigen Leiterbahnen verbunden wird.

Die Aufgabe wird auch gelöst durch einen Multilayer mit mindestens einem Halbleiter-Bauelement, das von einem Gehäuse umgeben ist, bei der erfindungsgemäß
- das Gehäuse auf einer Montagefläche des Multilayers sitzt,
- der Multilayer mehrere Bohrungen aufweist, die in der Montagefläche münden und an deren Innenflächen einige der im Multilayer enthaltenen flächigen Leiterbahnen enden und
- die Bohrungen mit einem Lotmaterial gefüllt sind, das eine thermische und elektrische Verbindung zwischen dem Gehäuse und zumindest einem Teil der flächigen Leiterbahnen bildet.

Vorteilhafte Weiterbildungen der Erfindung sind den Unteransprüchen zu entnehmen.

Die Vorteile der Erfindung liegen insbesondere darin, daß einerseits eine wirksame Wärmeabfuhr über den Multilayer und andererseits ein mikrowellengerechter Anschluß auf dem Multilayer mit einem Montagevorgang und ohne zusätzliche Maßnahmen erreicht werden.

Ein Ausführungsbeispiel der Erfindung wird im folgenden anhand der Zeichnung erläutert. Es zeigen:
- Fig. 1: einen erfindungsgemäßen Multilayer in einer vergrößerten Teil-Schnittansicht und
- Fig. 2: den Multilayer nach Fig. 1 in einer vergrößerten Teil-Draufsicht.

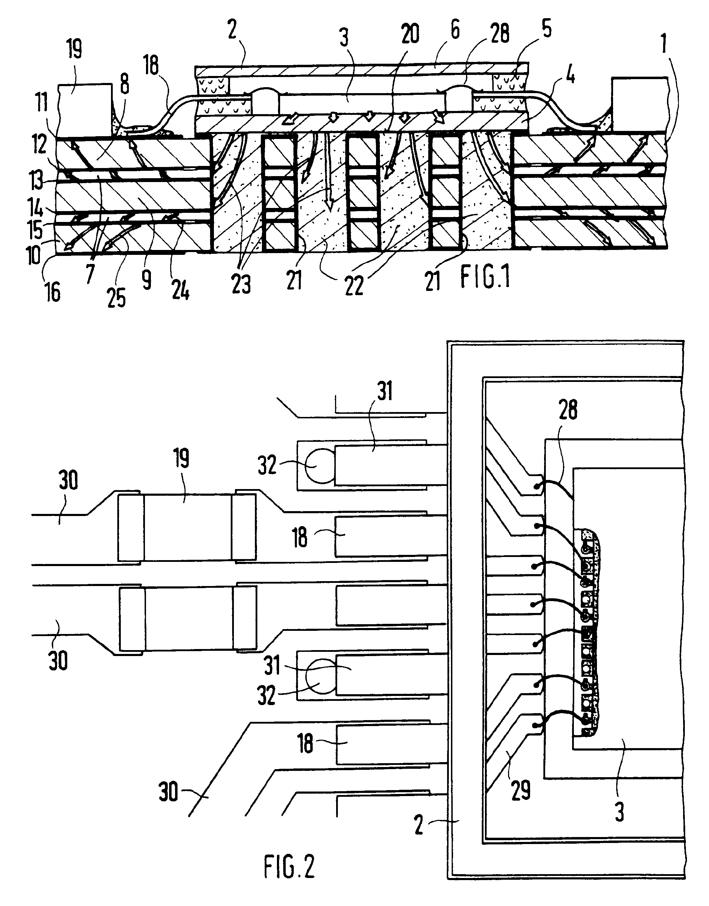

Auf dem Multilayer 1 ist ein Gehäuse 2 befestigt, das einen Chip 3 auf Siliziumbasis enthält (Fig. 1). Dieses Gehäuse besteht aus einem ebenen Gehäuseboden 4 aus Metall, einer Gehäusewand 5 aus Keramik und einem ebenfalls metallischen Gehäusedeckel 6.

Wegen der Anforderungen an die Gehäuse von Hochgeschwindigkeitschips ist das Gehäuse 2 in einem Anwendungsfall als 32-poliges Mikrowellengehäuse mit Metallboden und mit den Abmessungen 6 mm x 6 mm x 1 mm ausgeführt worden.

Andererseits werden bei Hochgeschwindigkeitsschaltungen nicht nur an das Gehäuse, sondern auch an die Anschlüsse und die Montage eines solchen Mikrowellengehäuses auf dem Multilayer besondere Anforderungen gestellt:
- Für die signalführenden Leitungen werden wellenwiderstandsgerechte Streifenleitungen bis an die Anschlußpins oder -beinchen der Gehäuse benötigt.
- Die Abschlußwiderstände der Signalleitungen sind ganz dicht an den Anschlußpins vorzusehen, um reflexionsfreie Abschlüsse zu erhalten.
- Außerdem sind die erforderlichen Trennkondensatoren dicht bei den Anschlußpins anzubringen.
- Die Abblockkondensatoren für die Betriebsspannung sind ebenfalls dicht bei den Anschlußpins anzuordnen, um die störenden Leitungsinduktivitäten gering zu halten.
- Es ist eine flächenhafte und damit induktivitätsarme Zuführung von Masse und Betriebsspannung vorzusehen.
- Der Gehäuseboden ist an die negative Betriebsspannung anzuschließen.
- Es muß eine gute Wärmeabführung vom Gehäuseboden und zwar ohne eine mechanisch aufwendige Konstruktion, erreicht werden. Der Anschluß des Gehäuses muß einfach und gut herzustellen sein.

Die Forderungen an die elektrischen Anschlüsse haben zur Folge, daß in der Umgebung des Mikrowellen-Gehäuses 2 der Platz vollständig beansprucht wird von Signalleitungen und SMD-Bauelementen. Das Problem der Kühlung wird durch die kleine Bodenfläche und die negative Betriebsspannung am Gehäuseboden vergrößert. Für die Wärmeabführung scheidet deshalb eine konventionelle Lösung mit Kühlkörper und mechanischer Klemmvorrichtung aus.

Die erfindungsgemäße Multilayer 1 ist so ausgeführt, daß sowohl die Forderung nach einem mikrowellengerechten Anschluß erfüllt, als auch eine ausreichende Kühlung des Chips 3 sichergestellt werden kann.

Bei einem Gehäuse 2 mit 32 Anschlüssen und den weiter oben genannten Abmessungen beträgt das Pinraster lediglich 0,76 mm. Der Multilayer 1 ist sechslagig aus dem genormten dielektrischen Epoxid-Werkstoff FR4 hergestellt. Drei Lagen Dielektrikum 8, 9 und 10 - jeweils beidseitig mit einer Kupfer-Kaschierung versehen - sind durch zwei Klebefolien 7 miteinander verbunden. Es ergeben sich somit sechs durch Dielektrikum-Schichten getrennte Metallschichten: eine erste oder oberste Metallschicht 11, die die als Streifenleitungen ausgebildeten Leiterbahnen enthält; eine zweite Metallschicht 12, die an Masse liegt; eine dritte und vierte Metallschicht 13 und 14, die an einer ersten Betriebsspannung U_{EE} von z.B. minus 5 Volt liegen; eine fünfte Metallschicht 15, die an einer zweiten Betriebsspannung U_{TT} von z.B. minus 2 Volt liegt, und eine sechste oder unterste Metallschicht 16, die an Masse liegt.

Die Dielektrikum-Schichten 8 bis 10 sind 0,36 mm dick, daraus ergibt sich für wellenwiderstandsgerechte Streifenleitungen eine Breite von 0,64 mm. Mit diesen Abmessungen lassen sich alle Signalleitungen als 50-Ohm-Streifenleitungen bis dicht an die Anschlußpins 18 des Halbleiterplättchens oder Chips 3 heranführen. Einige SMD-Bauelemente 19, die zum einwandfreien Betrieb der Hochgeschwindigkeitsschaltung erforderlich sind, sind ebenfalls dicht um das Gehäuse 2 herum angeordnet. Da zum Zuführen von Signale zum Chip 3 wie erwähnt, nur die oberste Metallschicht 11 als Leiterbahnebene benötigt wird, sind die restlichen fünf Metallschicht-Ebenen vollflächig ausgeführt. Sie eignen sich damit sehr gut einerseits als Leitungen für Masse und Betriebsspannungen und andererseits zum Abführen von in dem Chip 3 erzeugter Wärme.

Der Multilayer 1 weist eine Montagefläche 20 auf, der das Chip-Gehäuse 2 mit seinem metallischen Gehäuseboden 4 sitzt. In dem Bereich der Montagefläche 20 weist der Multilayer 1 mehrere durchgehende Bohrungen 21 auf. Diese Bohrungen 21 sind gleichmäßig über den Bereich der Montagefläche 20 verteilt angeordnet, in dem Ausführungsbeispiel ist es eine Anordnung von 16 Bohrungen mit einheitlichem Rasterabstand. Die Bohrungen 21 werden von der Rück- oder Unterseite des Multilayers 1 aus mit einem schmelzflüssigen Lot vollständig aufgefüllt und dabei der Gehäuseboden 4 mit der Montagefläche 20 des Multilayers 1 verlötet. Es bilden sich dabei die Bohrungen 21 ganz ausfüllende Durchkontaktierungen 22 aus. Als Lot wird z.B. ein Indium-Zinn-Lot mit einem Schmelzpunkt von 117°C verwendet.

Die Durchkontaktierungen 22 stellen sowohl einen guten elektrischen Kontakt als auch einen guten thermischen Verbund zum Gehäuseboden 4 her. Sie sind wiederum mit den beiden inneren Metallschichten 13 und 14 und damit der ersten negativen Betriebsspannung verbunden. Diese Schichten oder Innenlagen 13 und 14 bilden flächenhafte Versorgungsebenen, die zusammen mit dem direkten und flächigen Kontakt des Chips 3 über den Gehäuseboden 4 einen sehr induktivitätsarmen Spannungsanschluß ergeben. Andererseits bilden die Metallschichten 12, 13 und 15, 16 Masse- und Versorgungsebenen, die sehr gute HF-Abblockkondensatoren mit sehr geringen Zuleitungsinduktivitäten ergeben. Eventuelle Resonanzeffekte der Abblockkondensatoren und der Serieninduktivitäten werden durch das verlustbehaftete Dielektrikum der Schichten 8, 9 und 10 unterdrückt.

Die Durchkontaktierungen ergeben einen sehr guten thermischen Übergang von dem Gehäuseboden 4 zu den inneren Metallschichten 13 und 14, so daß die Verlustleistung des Chips 3 über diese Metallschichten 13, 14 rasch weitergeleitet werden kann. Durch den flächenhaften Verbund der einzelnen Lagen des Multilayers 1 wird die Wärme gut auf alle sechs Metallschichten 11 bis 16 ganzflächig verteilt und von dort über die Oberfläche an die Umgebung abgegeben. Die Richtung des Wärmeflusses von dem Chip 3 in die inneren Metallschichten und von dort zu den Oberflächen der Leiterplatte 1 ist in der Zeichnung mit Pfeilen 23, 24 und 25 angedeutet.

Die Dielektrikum-Schichten 8, 9 und 10 sind jeweils 0,36 mm dick. Die Klebefolien 7, die die beidseitig metallisierten Dielektrikum-Schichten 8 und 9 bzw. 9 und 10 paarweise miteinander verbinden, sind jeweils 0,1 mm dick. Die Kupfer-Metallisierungen 11 bis 16 schließlich, sind jeweils 35 »m dick. Dies ergibt eine Gesamtstärke des Multilayers 1 von 1,6 mm. Die anderen beiden Abmessungen des Multilayers 1 betragen 100 mm x 160 mm.

Aus der Draufsicht (Fig. 2) ist ersichtlich, wie die einzelnen Anschlüsse des in dem Gehäuse 2 angeordneten Chips 3 über Bonddrähte 28 mit inneren Anschlußpads 29 und über diese mit den äußeren Anschlußpins 18 verbunden sind. Die Anschlußpins 18 ihrerseits sind mit Signalleitungen 30 verbunden, die als 50-Ohm-Streifenleitungen ausgeführt sind. In der Nähe der Anschlußpins 18 sind die SMD-Bauelemente 19 an die Signalleitungen 30 angeschlossen. Diese SMD-Bauelemente 19 sind z.B. Abblockkondensatoren, Koppelkondensatoren oder Abschlußwiderstände. Einzelne der Anschlußpins 31 sind über Durchkontaktierungen 32 mit Masse verbunden.

Auf die vorstehend beschriebene Art auf Multilayern 1 montierte Chips 3 in der Ausführung als Silizium-Bipolar-Schaltungen konnten mit Signalströmen von bis zu 2,6 Gbit/s erfolgreich betrieben werden. Bei einer Verlustleistung von 2 Watt wurde ein Wärmewiderstand vom Silizium-Chip zur umgebenden Luft von nur 13 grad/W gemessen. Der Wärmewiderstand kann auch noch weiter gesenkt werden, wenn die Wärme zusätzlich über eine metallisierte Auflagefläche von der Multilayerrückseite abgeführt wird.

Mit der beschriebenen Montageart von Halbleiter-Bauelementen für Hochgeschwindigkeiten ist es somit möglich, ansonsten als Standard-Multilayer ausgebildete Anordnungen auch noch in dem Frequenzbereich bis zu einigen GHz erfolgreich einzusetzen. Es ist deshalb nicht nötig, wegen der elektrischen und thermischen Anforderungen an die Werkstoffe und die Konstruktion auf aufwendige und teuere Keramik-Gehäuse und -Platinen zurückzugreifen.

## Patentansprüche

1. Verfahren zum Montieren eines mit einem Gehäuse versehenen Halbleiter-Bauelementes auf einer Leiterplatte, wobei
- die Leiterplatte als Multilayer ausgebildet wird,
- der Multilayer mit durchgehenden Bohrungen versehen wird, welche in einer auf ihm vorhandenen Montagefläche münden, und einige der im Multilayer enthaltenen flächigen Leiterbahnen bis zur Innenfläche der Bohrungen geführt werden,
- der Gehäuseboden auf die Montagefläche aufgesetzt wird, und
- die Bohrungen mit einem schmelzflüssigen Lot gefüllt und dadurch das Gehäuse thermisch und elektrisch leitend mit den flächigen Leiterbahnen verbunden wird.

2. Multilayer mit mindestens einem Halbleiter-Bauelement, das von einem Gehäuse umgeben ist, wobei
- das Gehäuse (2) auf einer Montagefläche (20) des Multilayers (1) sitzt,
- der Multilayer (1) mehrere Bohrungen (21) aufweist, die in der Montagefläche (20) münden und an deren Innenfläche einige der im Multilayer (1) enthaltenen flächigen Leiterbahnen (13, 14) enden, und
- die Bohrungen (21) mit einem Lotmaterial gefüllt sind, das eine thermische und elektrische Verbindung zwischen dem Gehäuse (2) und den flächigen Leiterbahnen (13, 14) bildet.

3. Multilayer nach Anspruch 2,
dadurch gekennzeichnet, daß die Bohrungen (21) in gleichmäßigen Rasterabständen über die Montagefläche (20) verteilt sind.

4. Multilayer nach Anspruch 2,
dadurch gekennzeichnet, daß zwei flächige Leiterbahnen (12, 13), von denen eine (13) an der Versorgungsspannung und die andere (12) an Masse liegt und die beide bis in die Nähe der Anschlüsse (18) des Halbleiter-Bauelements (3) reichen, einen Abblockkondensator mit sehr kleiner Induktivität bilden.

5. Multilayer nach Anspruch 2,
dadurch gekennzeichnet, daß er Dielektrikumslagen (8, 9, 10) mit einer Dicke x und Streifenleitungen (30) mit einer Breite y aufweist, wobei das Verhältnis y : x so gewählt ist, daß die Streifenleitungen (30) einen vorgegebenen Wellenwiderstand Z aufweisen.

6. Multilayer nach Anspruch 5,
dadurch gekennzeichnet, daß x = 0,36 mm und y = 0,64 mm ist, woraus sich ein Verhältnis y : x = 1,8 und daraus bei einem Werkstoff mit einer Dielektrizitätszahl 4 ein Wellenwiderstand von Z = 50 Ohm ergibt.

7. Multilayer nach Anspruch 2,
dadurch gekennzeichnet, daß er mit oberflächenmontierten Bauelementen (19) versehen ist, die direkt um das Gehäuse (2) herum angeordnet sind.

## Claims

1. Method for mounting a semiconductor component which is provided with a package on a printed circuit board, wherein
- the printed circuit board is designed as a multilayer printed wiring board which comprises laminar conductor tracks separated by dielectric layers,
- the multilayer printed wiring board is provided with through holes which open into a mounting surface present on it and some of the laminar conductor tracks contained in the multilayer printed wiring board are brought up to the internal surface of the holes,
- the package base is placed on the mounting surface, and
- the holes are filled with a molten solder and the package is thereby connected thermally and in an electrically conducting manner to the laminar conductor tracks.

2. Multilayer printed wiring board which comprises laminar conductor tracks separated by dielectric layers and has at least one semiconductor component surrounded by a package, wherein
- the package (2) is seated on a mounting surface (20) of the multilayer printed wiring board (1),
- the multilayer printed wiring board (1) has a plurality of holes (21) which open into the mounting surface (20) and at whose internal surface some of the laminar conductor tracks (13, 14) contained in the multilayer printed wiring board (1) terminate, and
- the holes (21) are filled with a solder material which forms a thermal and electrical connection between the package (2) and the laminar conductor tracks (13, 14).

3. Multilayer printed wiring board according to Claim 2, characterized in that the holes (21) are distributed in uniform grid spacings over the mounting area (20).

4. Multilayer printed wiring board according to Claim 2, characterized in that two laminar conductor tracks (12, 13), one (13) of which is connected to the supply voltage and the other (12) is connected to earth and which both extend up to the vicinity of the connections (18) of the semiconductor component (3), form a blocking capacitor having very low inductance.

5. Multilayer printed wiring board according to Claim 2, characterized in that it has dielectric plies (8, 9, 10) having a thickness x and striplines (30) having a width y, the ratio y:x being chosen so that the striplines (30) have a specified characteristic impedance Z.

6. Multilayer printed wiring board according to Claim 5, characterized in that x = 0.36 mm and y = 0.64 mm, which results in a ratio of y:x = 1.8, the latter resulting in a characteristic impedance of Z = 50 ohm for a material having a relative permittivity of 4.

7. Multilayer printed wiring board according to Claim 2, characterized in that it is provided with surface-mounted components (19) which are disposed immediately around the package (2).

## Revendications

1. Procédé pour le montage, sur une carte à circuit imprimé, d'un composant à semiconducteur muni d'un boîtier, dans lequel
- la carte à circuit imprimé est conçue sous forme d'un élément multicouche,
- l'élément multicouche est muni de perçage traversants qui débouchent dans une surface de montage qui s'y trouve et quelques-uns des rubans conducteurs plans contenus dans l'élément multicouche sont amenés jusqu'à la surface intérieure des perçages,
- le fond du boîtier repose sur la surface de montage et
- les perçages sont remplis d'une brasure à l'état de bain de fusion et, de ce fait, le boîtier est relié, avec conduction thermique et électrique, avec les rubans conducteurs plans.

2. Elément multicouche comportant au moins un composant à semiconducteur qui est entouré d'un boîtier, dans lequel
- le boîtier (2) repose sur une surface de montage (20) de l'élément multicouche (1),
- I'élément multicouche (1) présente plusieurs perçages (21) qui débouchent dans la surface de montage (20) et quelques-uns des rubans conducteurs plans (13, 14) contenus dans l'élément multicouche (1) se terminent à la surface intérieure de ces perçages et
- les perçages (21) sont remplis d'un matériau de brasure qui forme une liaison thermique et électrique entre le boîtier (2) et les rubans conducteurs plans (13, 14).

3. Elément multicouche selon la revendication 2,
caractérisé par le fait que les perçages sont répartis à intervalles de trame régulièrs sur la surface de montage (20).

4. Elément multicouche selon la revendication 2,
caractérisé par le fait que deux rubans conducteurs plans (12, 13), dont l'un (13) est relié à la tension d'alimentation et dont l'autre (12) est à la masse et dont les deux vont jusqu'au voisinage des bornes (18) du composant à semiconducteur (3), forment un condensateur de blocage de très faible inductance.

5. Elément multicouche selon la revendication 2,
caractérisé par le fait qu'il présente des couches de diélectrique (8, 9, 10) d'une épaisseur x et des microbandes conductrices (30) d'une largeur y, le rapport y :x étant choisi de façon que les microbandes conductrices (30) présentent une impédance caractéristique z prescrite.

6. Elément multicouche selon la revendication 5,
caractérisé par le fait que x = 0,36mm et y = 0,64mm, ce qui donne un rapport y : x = 1,8 et donc, dans le cas d'un matériau de constante diélectrique 4, une impédance caractéristique de Z = 50 Ohms.

7. Elément multicouche selon la revendication 2,
caractérisé par le fait qu'il présente des composants (9) montés en surface qui sont directement disposés autour du boîtier (2).
